# EUROPEAN PATENT APPLICATION

(11) **EP 4 597 163 A1**
(43) Date of publication of application: **06.08.2025**
(21) Application number: 24174437.4
(22) Date of filing: 07.05.2024
(51) Int. Cl.: G01S 7/521

(54) **AUTOMOTIVE ULTRASOUND SENSOR**

(30) Priority: 31.01.2024 TW 113103824
(71) Applicant: Tung Thih Electronic Co., Ltd., Taoyuan City 338 (TW)
(72) Inventor: Lin, Hung-Shuan, 338 Taoyuan City (TW); Wang, Chih-En, 338 Taoyuan City (TW); Lin, Tzu-Chieh, 338 Taoyuan City (TW); Chen, Hsin-Yuan, 338 Taoyuan City (TW); Tai, Peng-Yuan, 338 Taoyuan City (TW)
(74) Representative: DTS Patent- und Rechtsanwälte PartmbB

(57) **Abstract**

An automotive sensor (1) includes a body (100) and a connecting member (200). The body (100) forms a workspace (170). The connecting member (200) is inserted into the body (100) and includes a first end (222), and the first end (222) is arranged in the workspace (170) and includes a holding portion (222a).

## Description

### BACKGROUND OF THE INVENTION

### 1. Field of the Invention

The present disclosure relates to an automotive sensor, and in particular relates to an automotive sensor that contributes to the efficiency of an internal element assembly.

### 2. Description of the Related Art

Cars are one of the indispensable means of transportation in people's lives. Generally speaking, in order to avoid collisions between an automobile and other automobiles or obstacles during the process of moving (forward or reverse). Sensors that can detect the distance between the automotive body and other automobiles or obstacles are usually equipped around the automotive body, and non-contact detection technologies such as ultrasound and light sensors are used to inform the driver of the safety distances when driving or reversing in real time, so as to protect the safety of automobiles, people, and pedestrians caused by automobile collisions.

### BRIEF SUMMARY OF THE INVENTION

A conventional automotive sensor includes a sensor (transducer) that can realize the detection technology described above, a control element that calculates and interprets sensor signals, a connecting terminal that electrically connects the sensor to the control element, and a body that can accommodate these elements. However, because of the relatively narrow space inside the body, when creating an electrical connection between elements, such as soldering a wire between a sensor and a connecting terminal, the displacement between the wire and the connecting terminal easily occurs, It will lead to the entire soldering and assembly process required to be carried out manually, which reduces the efficiency of assembly and increases labor costs.

The present invention provides an automotive sensor that contributes to the efficiency of an internal element assembly, in order to improve assembly efficiency and reduce labor costs.

The present disclosure provides an automotive sensor, including a body and a connecting member. The body forms a workspace. The connecting member is inserted into the body and includes a first end, and the first end is arranged in the workspace and includes a holding portion.

In an embodiment, the connecting member further includes an insertion portion and an extension portion, the insertion portion is inserted into the body, and the extension portion is attached on a surface of the body.

In an embodiment, the surface includes a horizontal surface and a vertical surface, and the extension portion includes a first extension section and a second extension section. The first extension section is attached on the horizontal surface and the second extension section is bent relative to the first extension section and attached on the vertical surface.

In an embodiment, the first end is arranged at the extension portion.

In an embodiment, the holding portion forms a groove or a hole.

In an embodiment, a surface of the holding portion has adhesiveness.

In an embodiment, the workspace includes a first workspace and a second workspace, cross-sectional dimensions of the first workspace are larger than those of the second workspace, and the first end is arranged in the first workspace.

In an embodiment, the automotive sensor further includes a control element, the connecting member further includes a second end, and the second end is electrically connected to the control element.

In an embodiment, the second end is inserted or soldered to the control element.

In an embodiment, the body is integrated with the connecting member.

Accordingly, the connecting member of the automotive sensor of the present disclosure includes the first end with the holding portion, so when the electrical connection between the elements is established, the conductive element can be held at the first end, and the relative position between the elements is adjusted and then soldered, so that the automation of the assembly process can be realized, and then the effect of improving assembly efficiency and reducing labor cost can be achieved.

In order to facilitate the above features and advantages of the present disclosure to be more obvious and easier to understand, embodiments specially given together with the attached drawings for the detailed description of the present disclosure are provided as below.

### BRIEF DESCRIPTION OF THE DRAWINGS

FIG. 1 is a schematic perspective view of the automotive sensor of a first embodiment of the present disclosure.
FIG. 2 is a schematic top view of FIG. 1.
FIG. 3 is a schematic perspective view of the connecting member in FIG. 2.
FIG. 4 is a schematic cross-sectional view of FIG. 2 along the X-X section.
FIG. 5 is a schematic cross-sectional view of the automotive sensor of FIG. 2 and other elements along the X-X section after the assembly is completed.
FIG. 6 is a schematic top view of the automotive sensor of a second embodiment of the present disclosure.
FIG. 7 is a schematic perspective view of the connecting member in FIG. 6.
FIG. 8 is a schematic cross-sectional view of FIG. 6 along the Y-Y section.
FIG. 9 is a schematic perspective view of the connecting member of the automotive sensor of a third embodiment of the present disclosure.
FIG. 10 is a cross-sectional schematic view of the connecting member of FIG. 9 along the Y-Y profile when the assembly is completed.

### DETAILED DESCRIPTION OF THE INVENTION

The aforementioned and other technical contents, characteristics and effects of the present disclosure can be clearly presented by the detailed description of preferable embodiments together with the attached drawings. It is worth mentioning that the direction terms mentioned in the following embodiments, such as: top, bottom, left, right, front or rear are only referred to the direction of the drawings. Therefore, the directional terms used are intended to illustrate, not to limit, the disclosure. In addition, in the following embodiments, the same or similar elements will use the same or similar reference numerals.

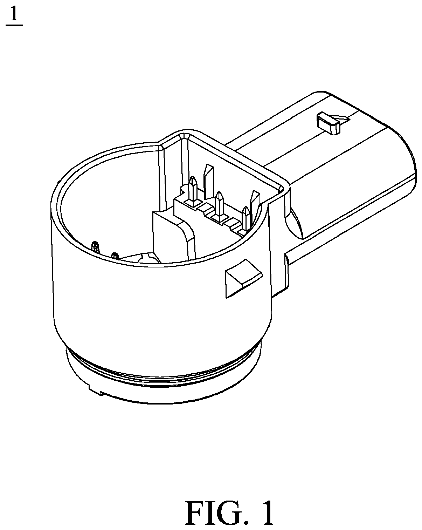

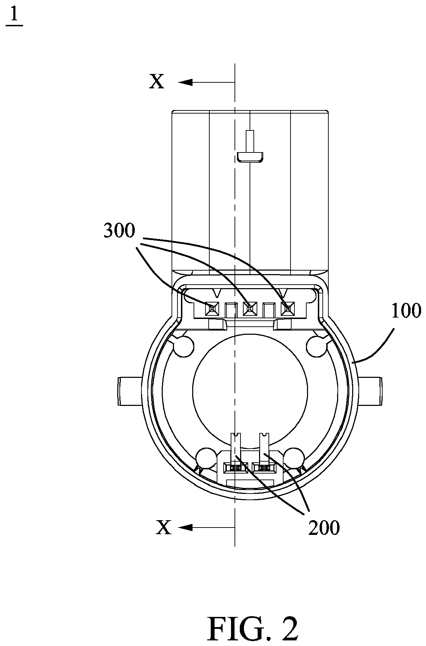

Referring to FIGS. 1 and 2, FIG. 1 is a schematic perspective view of an automotive sensor of an embodiment of the present disclosure, and FIG. 2 is a schematic top view of FIG. 1. The automotive sensor 1 of the present embodiment includes a body 100 and at least one connecting member 200, wherein the body 100 is used for accommodating at least a portion of the connecting member 200. The connecting member 200, for example, is a connecting terminal for electrically connecting a sensing element and a control element of the automotive sensor 1. In this embodiment, the quantity, for example, is two and are arranged on the body 100. In some embodiments, the automotive sensor 1 may also include at least one auxiliary connecting member 300, wherein the auxiliary connecting member 300, for example, is a connecting terminal that can be physically connected with a sensing element or a control element directly. In an embodiment, the quantity, for example, is three and are placed on the body 100.

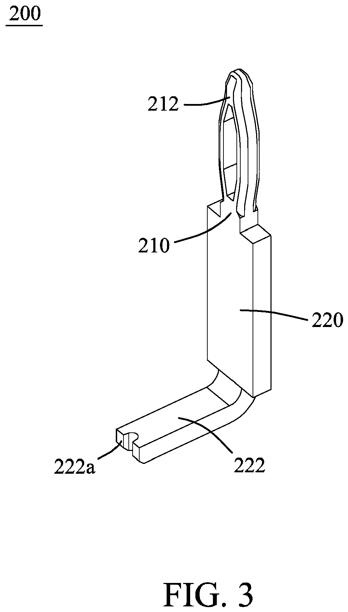

Referring to FIG. 3, which is a schematic perspective view of the connecting member in FIG. 2. As shown in the figure, the connecting member 200 may include a connecting body 210 and an insertion portion 220, wherein the connecting body 210 is used for connecting one of the sensing element and the control element. The insertion portion 220 is connected to the connecting body 210, and the connecting member 200 is suitable for inserting into the body 100 via the insertion portion 220. In an embodiment, the connecting member 200 further includes a first end 222, wherein the first end 222 is arranged on one end of the insertion portion 220, which is away from the connecting body 210 and bent relative to the insertion portion 220. The first end 222 has a holding portion 222a on one end away from the insertion portion 220, and the holding portion 222a is suitable for holding a conductive element used to connect the sensing element.

Specifically, because the size of each element of the automotive sensor 1 is small, when the electrical connection between the elements is established, for example, a wire is soldered between the sensing element and the connecting terminal, the relative displacement between the wire and the connecting terminal easily occurs in the assembly process, so that the whole soldering and assembly process are required to be carried out manually, which reduces the efficiency of assembly and increases labor cost. Therefore, the first end 222 of the connecting member 200 of an embodiment includes the holding portion 222a, and a part of the wire can be temporarily held to the holding portion 222a before soldering, and the relative position between the sensing element and the connecting member 200 is adjusted. In the process of displacement, a part of the wire is held on the holding portion 222a and will not be separated from the connecting member 200, so when the sensing element and the connecting member 200 are both arranged at the final position after assembly, the wire that is held on the first end 222 and the connecting member 200 can be soldered quickly and reliably, and the automation of the assembly process can be realized, and the effect of improving assembly efficiency and reducing labor cost is achieved.

Further, in an embodiment, the holding portion 222a, for example, forms a slightly semicircular groove that is suitable for holding at least a part of the wire from the side. In other embodiments, in order to facilitate the arrangement of the wire in the groove, or to make the wire more firmly clamped in the groove, the arc enclosed by the groove may also be smaller than the semicircle or larger than the semicircle, or a V-shaped hook is formed without being designed into a circular groove, or even directly forms a hole with a closed profile, and the wire is inserted in the hole, as long as the purpose of partially or completely holding or clamping the wire can be achieved, the present disclosure does not limit thereto.

In addition, in some embodiments, the holding portion 222a may also hold the wire by other means than clamping the wire. For example, a surface of the holding portion 222a can be configured with adhesive suitable for permanently or temporarily attachment to the wire, so that the surface of the holding portion 222a has adhesiveness. Thus, before assembling, the wire to be soldered can be attached to the holding portion 222a, and the connecting member 200 and the sensing element can be soldered after being placed at the specified position, which also has the benefits of improving the soldering success rate.

In addition, the connecting member 200 of an embodiment further includes a second end 212, wherein the second end 212 is located on one end of the connecting body 210, located away from the insertion portion 220, and its shape, for example, is a fisheye pin and extends parallel from the connecting body 210. Through this configuration, before or after the first end 222 completes the soldering process, the second end 212 can be directly press-fitted to the other of the control element or the sensing element, and the electrical connection between the two parts can be quickly completed.

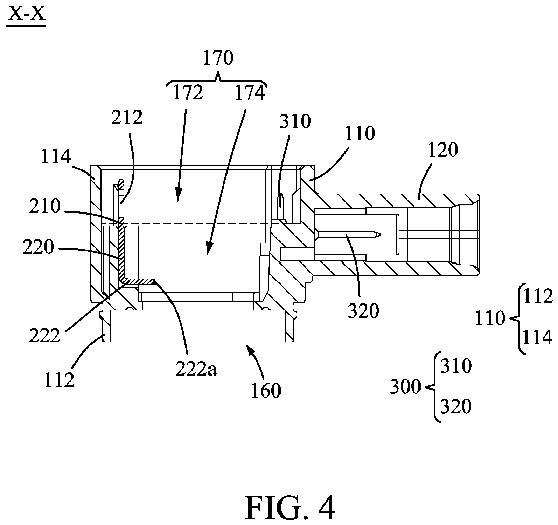

Referring to FIG. 4, which is a schematic cross-sectional view of FIG. 2 along the X-X section. Specifically, the body 100 includes a base portion 110 and a mounting portion 120, wherein the base portion 110 may include a front-end 112 and a back-end 114, the front-end 112 forms a front-end opening 160, and the back-end 114 forms a workspace 170. As shown in FIG. 2 and FIG. 4, the base portion 110 can form a groove for clamping the connecting member 200, and when the user wants to carry out the assembly process between the connecting member 200 and the body 100, the connecting member 200 can be pressed into the groove on the base portion 110, so that the first end 222 and the holding portion 222a are arranged in the workspace 170. When the user wants to disengage the connecting member 200 from the body 100, the connecting body 210 can also be clamped by a tool such as a vice or clamp, and force to be applied opposite to the mounting direction to pull out the connecting member 200 from the base portion 110. In other words, the connecting member 200 of the present discloser is fitted into the body 100, but removable so that the reuse rate of the element can be improved.

In addition, the workspace 170 may include a first workspace 172 (a portion above the horizontal dashed line in FIG. 4) and a second workspace 174 (a portion below the horizontal dashed line in FIG. 4), and the second workspace 174 is communicated with the front-end opening 160 and the first workspace 172. As shown in FIG. 4, cross-sectional dimensions of the first workspace 172 are larger than those of the second workspace 174. Thus, the automotive sensor 1 can let the internal elements be clamped at specific positions through the size difference between the first workspace 172 and the second workspace 174, so that the goal of element fitting can be realized by the structure.

Alternatively, the mounting portion 120 is used for mounting and connecting with an automobile equipped with the automotive sensor 1, and has a cavity formed inside. As shown in FIG. 4, the auxiliary connecting member 300 may include a first auxiliary end 310 and a second auxiliary end 320, wherein the first auxiliary end 310 is arranged in the first workspace 172, the second auxiliary end 320 is connected to the first auxiliary end 310, and bent relative to the first auxiliary end 310, and the second auxiliary end 320 is arranged in the cavity of the mounting portion 120. Through such a configuration, the auxiliary connecting member 300 can receive power from the automobile through the second auxiliary end 320, and provide power to various electronic elements located in the workspace 170 through the first auxiliary end 310. In an embodiment, the auxiliary connecting member 300, for example, is injection molded together with the body 100, that is, the auxiliary connecting member 300 is integrally formed with the body 100. Based on actual needs, the connecting member 200 can also be integrally formed with the body 100, thus saving the steps required for subsequent assembly, but the present disclosure does not limit thereto.

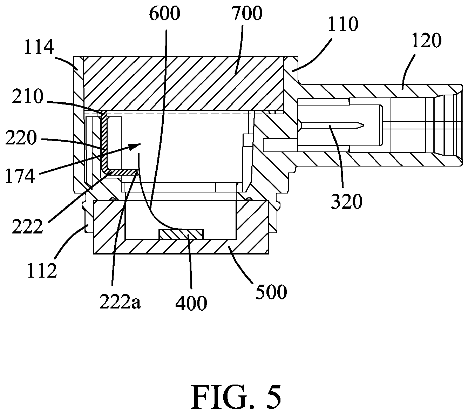

Referring to FIG. 5, which is a schematic cross-sectional view of the automotive sensor of FIG. 2 and other elements along the X-X section after the assembly is completed. The following will be described in detail for the process of soldering and assembling the automotive sensor 1 of an embodiment. First, the user may first arrange a sensor 400 in a housing 500 for accommodating the sensor 400, and make the sensor 400 and the housing 500 relatively fixed. After that, the connecting member 200 is inserted in the groove of the base portion of 110 (if the connecting member 200 is integrated with the body 100, this step can be omitted), one end of the a conductive element 600 is to be welded to the surface of the sensor 400, and the body portion of the conductive element 600 is fixed to the holding portion 222a of the connecting member 200, by clamping, or attaching, wherein the conductive element 600, for example, is a wire or a flexible circuit board, and the present disclosure does not limit thereto. Then, the housing 500 is clamped in the front-end opening 160, and the conductive element 600 held on the holding portion 222a is soldered with the first end 222, and the excess portion of conductive element 600 should be removed according to the actual situation. Finally, a control element 700 is pressed on the second end 212 of the connecting member 200 and the first auxiliary end 310 of the auxiliary connecting member 300 through press-fitting, so that the second end 212 and the first auxiliary end 310 are electrically connected to the control element 700, wherein the control element 700, for example, is a circuit board with a logic loop, thereby completing the assembly and electrical connection of all internal elements of the automotive sensor 1.

In an embodiment, although the second end 212 is a fisheye (press-fit) pin, and the physical electrical connection is completed by press-fitting the control element 700 to the second end 212, the present disclosure is not limited thereto. In other embodiments, the second end 212 may also be ordinary pins, and electrical connection between the second end 212 and the control element 700 is established by means of soldering.

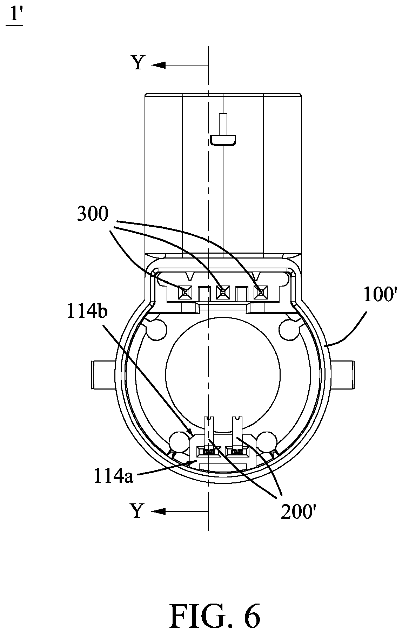

Referring to FIG. 6, which is a schematic top view of the automotive sensor of an embodiment of the present disclosure. The automotive sensor 1' is roughly similar to the automotive sensor 1 of the embodiment detailed above, and the main difference between the two is that: the connecting member 200' of the automotive sensor 1' is partially embedded in the body 100', and the connecting member 200' further includes an extension portion 230.

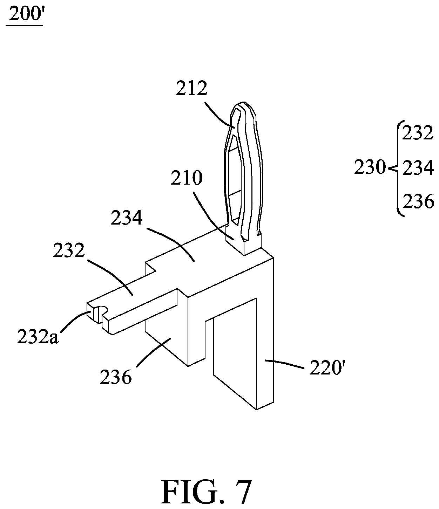

Referring to FIG. 7, which is a schematic perspective view of the connecting member in FIG. 6. As shown in the figure, the connecting member 200' includes a connecting body 210, an insertion portion 220', an extension portion 230, a first end 232, and a second end 212, wherein the insertion portion 220' is connected to the connecting body 210; the extension portion 230 extends and protrudes to the connecting body 210 and/or the insertion portion 220'. The first end 232 is arranged on the extension portion 230 and includes a holding portion 232a. The second end 212 is arranged on one end of the connecting body 210, which is away from the insertion portion 220' and the extension portion 230, and the shape, for example, is a fisheye(press-fit) pin and extends parallel to the connecting body 210.

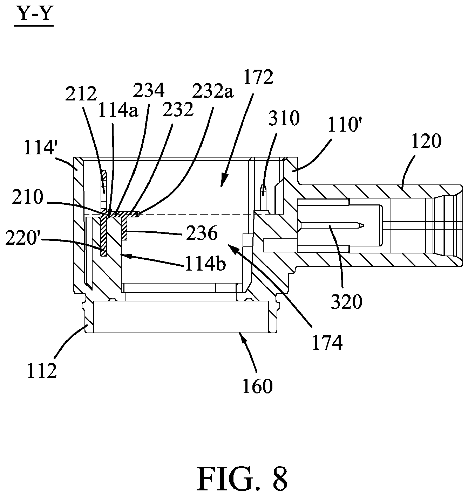

Referring to FIG. 7 and FIG. 8 together, FIG. 8 is a schematic cross-sectional view of FIG. 6 along the Y-Y section. Specifically, because the cross-sectional dimensions of the first workspace 172 are larger than those of the second workspace 174, if the first end 232 used for soldering the conductive element 600 can be arranged in the first workspace 172, the yield of the soldering process can be further improved. Therefore, as shown in FIG. 8, the connecting member 200' can be inserted into the base portion 110' through the insertion portion 220', the one end of the insertion portion 220' away from the connecting body 210 is embedded in the base portion 110', and the first end 232 is arranged on the extension portion 230 of the first workspace 172 at this time. Through this configuration, users can solder the connecting member 200' and the conductive element 600 in a larger workspace, thereby improving the yield of finished products.

In addition, since the first end 232 is arranged on the extension portion 230, the insertion portion 220' can be made of materials with higher temperature tolerance or higher mechanical strength than the connecting body 210 and the extension part 230 without the need to have electrical conductivity. In this way, even if the body 100' and the connecting member 200' are integrally made by injection molding, the electrical conductivity and bonding strength of the connecting member 200' will not be affected.

Further, the extension portion 230 of an embodiment can be attached to the surface of the base portion 110', thereby enhancing the stability of the combination between the connecting member 200' and the body 100'. As shown in FIG. 6 and FIG. 8, the back-end 114 has a surface, the surface may include a horizontal surface 114a and a vertical surface 114b, and the vertical surface 114b is orthogonal to the horizontal surface 114a. Alternatively, the extension portion 230 may include a first extension section 234 and a second extension section 236, wherein the first extension section 234, for example, is connected between the connecting body 210 and the insertion portion 220', and the second extension section 236 is arranged on one end of the first extension section 234, which is away from the connecting body 210 and the insertion portion 220', and is bent relative to the first extension section 234. When the body 100' is relatively fixed with the connecting member 200', the first extension section 234 is attached to the horizontal surface 114a, and the second extension section 236 is attached to the vertical surface 114b. Through such a configuration, the connecting member 200' can not only strengthen the bonding strength between the connecting member 200' and the body 100' through the part other than the insertion portion 220', but the user can also choose to weld one end of the conductive element 600 away from the sensor 400 to the first end 232, the first extension section 234, or the second extension section 236, thereby reducing the difficulty of soldering the conductive element 600.

In an embodiment, although the first end 232 is arranged between the first extension section 234 and the second extension section 236, and the first end 232 extends and protrudes parallel to the first extension section 234, the present disclosure is not limited thereto. In other embodiments, the first end 232 may also be arranged at an end of the second extension section 236 or extend toward the upper right side of FIG. 8. In addition, the insertion portion 220' may also be integrally formed with the body 110, as long as the conductive element 600 can be smoothly held, all are within the scope of the present disclosure.

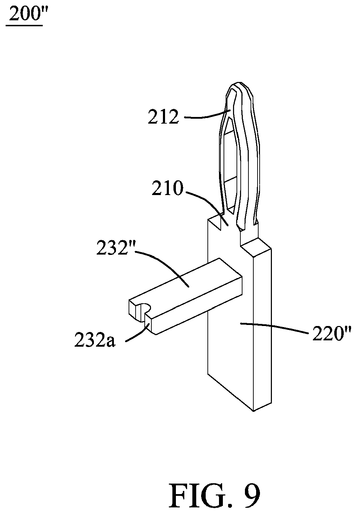

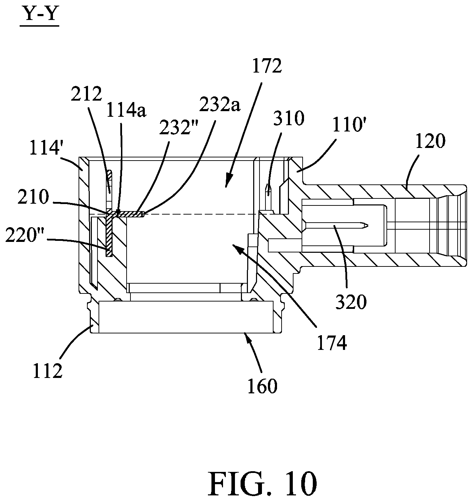

Referring to FIG. 9 and FIG. 10, FIG. 9 is a schematic perspective view of the connecting member of the automotive sensor of the third embodiment of the present disclosure, and FIG. 10 is a cross-sectional schematic view of the connecting member of FIG. 9 along the Y-Y section when the assembly is completed. The connecting member 200" of an embodiment is roughly similar to the connecting member 200' of the previous embodiment, and the main difference between the two is that the connecting member 200" fails to have an extension portion 230.

In detail, the connecting member 200" includes a connecting body 210, an insertion portion 220", a first end 232", and a second end 212, wherein the insertion portion 220" is connected to the connecting body 210. The first end 232" is arranged on the insertion portion 220" and includes a holding portion 232a. The second end is arranged on one end of the connecting body 210, which is away from the insertion portion 220", and the shape, for example, is a fisheye (press-fit) pin and extends parallel to the connecting body 210. Thus, when the connecting member 200" and the body 100' are assembled with each other or integrally formed, the first end 232 can be not only located in the first workspace 172 with a larger size, but the connecting member 200" also saves more material than the connecting member 200' of the previous embodiment, and the vertical position of the connecting member 200" can be adjusted according to the actual need, in order to determine whether to attach the first end 232" to the horizontal surface 114a to obtain greater support stability.

While the present invention has been described by means of preferable embodiments, those skilled in the art should understand the above description is merely embodiments of the invention, and it should not be considered to limit the scope of the invention. It should be noted that all changes and substitutions which come within the meaning and range of equivalency of the embodiments are intended to be embraced in the scope of the invention, and the technical features of the above embodiments may be appropriately combined, substituted, omitted, and varied without generating conceptual contradictions or structural conflicts. Therefore, the scope of the invention is defined by the claims.

## Claims

1. An automotive sensor (1, 1'), comprising:
a body (100, 100'), forming a workspace (170); and
a connecting member (200, 200', 200"), inserted into the body (100, 100') and comprising a first end (222, 232, 232"), the first end (222, 232, 232") is arranged in the workspace (170) and comprises a holding portion (222a, 232a).

2. The automotive sensor (1') according to claim 1, wherein the connecting member (200') further comprises an insertion portion (220') and an extension portion (230), the insertion portion (220') is inserted into the body (100'), and the extension portion (230) is attached on a surface of the body (100').

3. The automotive sensor (1') according to claim 2, wherein the surface comprises a horizontal surface (114a) and a vertical surface (114b), and the extension portion (230) comprises a first extension section (234) and a second extension section (236), the first extension section (234) is attached on the horizontal surface (114a), and the second extension section (236) is bent relative to the first extension section (234) and attached on the vertical surface (114b).

4. The automotive sensor (1') according to claim 2, wherein the first end (232) is arranged at the extension portion (230).

5. The automotive sensor (1, 1') according to claim 1, wherein the holding portion (222a, 232a) forms a groove or a hole.

6. The automotive sensor (1, 1') according to claim 1, wherein a surface of the holding portion (222a, 232a) has adhesiveness.

7. The automotive sensor according to claim 1, wherein the workspace (170) comprises a first workspace (172) and a second workspace (174), cross-sectional dimensions of the first workspace (172) are larger than those of the second workspace (174), and the first end (222, 232) is arranged in the first workspace (172).

8. The automotive sensor (1) according to claim 1, further comprising a control element (700), the connecting member (200) further comprises a second end (212), and the second end (212) is electrically connected to the control element (700).

9. The automotive sensor (1) according to claim 8, wherein the second end (212) is inserted or soldered to the control element (700).

10. The automotive sensor (1, 1') according to claim 1, wherein the body (100, 100') is integrally formed with the connecting member (200, 200', 200").
